# EUROPEAN PATENT SPECIFICATION

(11) **EP 0 545 604 B1**
(45) Date of publication and mention of the grant of the patent: **10.11.2004**
(21) Application number: 92310730.4
(22) Date of filing: 24.11.1992
(51) Int. Cl.: H01L 27/02, H01L 27/088

(54) **High-withstand voltage integrated circuit**
Integrierte Schaltung mit einer hohen Spannungsfestigkeit
Circuit intégré à haute tension de claquage

(30) Priority: 29.11.1991 JP 31568891
(43) Date of publication of application: 09.06.1993
(73) Proprietor: FUJI ELECTRIC CO. LTD., Kawasaki 210 (JP)
(72) Inventor: Fijihira, Tatsuhiko, Matsumoto-shi, Nagano 390 (JP); Nishiura, Masaharu, Matsumoto-shi, Nagano 390-02 (JP)
(74) Representative: Bridge-Butler, Alan James

(56) References cited:
- EP-A- 0 116 820
- EP-A- 0 276 850
- US-A- 4 984 202
- PATENT ABSTRACTS OF JAPAN vol. 011 no. 341 (E-554) ,7 November 1987 & JP-A-62 122262 (HITACHI LTD) 3 June 1987,
- PATENT ABSTRACTS OF JAPAN vol. 12 no. 153 (E-607) ,11 May 1988 & JP-A-62 269419 (FUJI ELECTRIC CO LTD) 21 November 1987,
- IEEE JOURNAL OF SOLID-STATE CIRCUITS, vol. 22, no. 3, June 1987 NEW YORK US, pages 437-441, T. FURUYAMA ET AL. 'A New On-Chip Voltage Converter for Submicrometer High-Density DRAM's'

## Description

The present invention relates to high-withstand voltage integrated circuit which has in its output stage a power element such as a high-withstand voltage MOSFET, and can be used in automobiles.

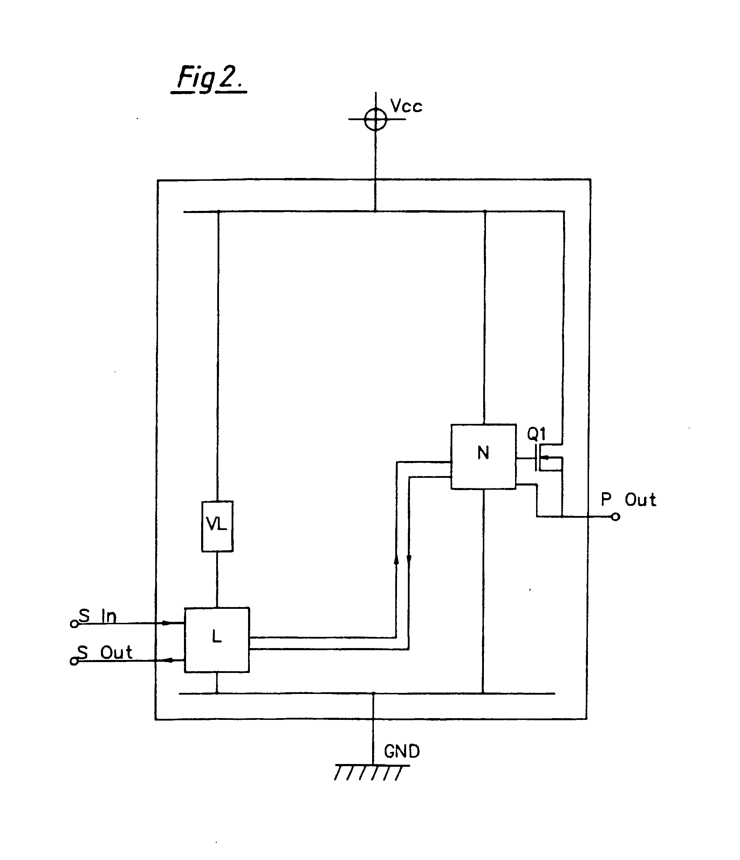

A high-withstand voltage integrated circuit (IC) in which a vertical power MOSFET, its control circuit and protective circuit are integrated in one semiconductor substrate is described by, for example, M. Glogolia, J. Tihanyi "Conf. Rec. IEEE Ind. Appl. Sor. Annu. Meet.", p 429 (1986), and is used under severe conditions such as power source voltage variations and surges, which are typically present in automobiles. This construction shows a circuit which can be used as a high voltage circuit N in the circuit shown in Figure 2 below.

Figure 2 is a simplified view of the internal circuit of a conventional high-withstand voltage IC. The high-withstand voltage IC consists of five terminals, i.e., a main power source terminal VCC, a ground terminal GND, power output terminal POUT, a signal input terminal SIN, and a signal output terminal SOUT. Meanwhile, the output stage power element consists of a high-side switch of an n-channel power MOSFET, the IC having come to be used gradually in the field of automotive electrical equipment because of its convenience and low loss capability. This circuit is basically divided into a low potential circuit L, which is supplied with power from low potential power source circuit VL, and a high voltage circuit N, which depends on the main power source VCC for its power supply. The low potential circuit L includes a digital circuit section that inputs and outputs signals to and from external sources, and a logic circuit for control. Moreover, the high voltage circuit N includes a drive circuit for the output stage power element Q1 and an analogue circuit such as a detection circuit to check the voltage, current, and temperature and feedback circuit.

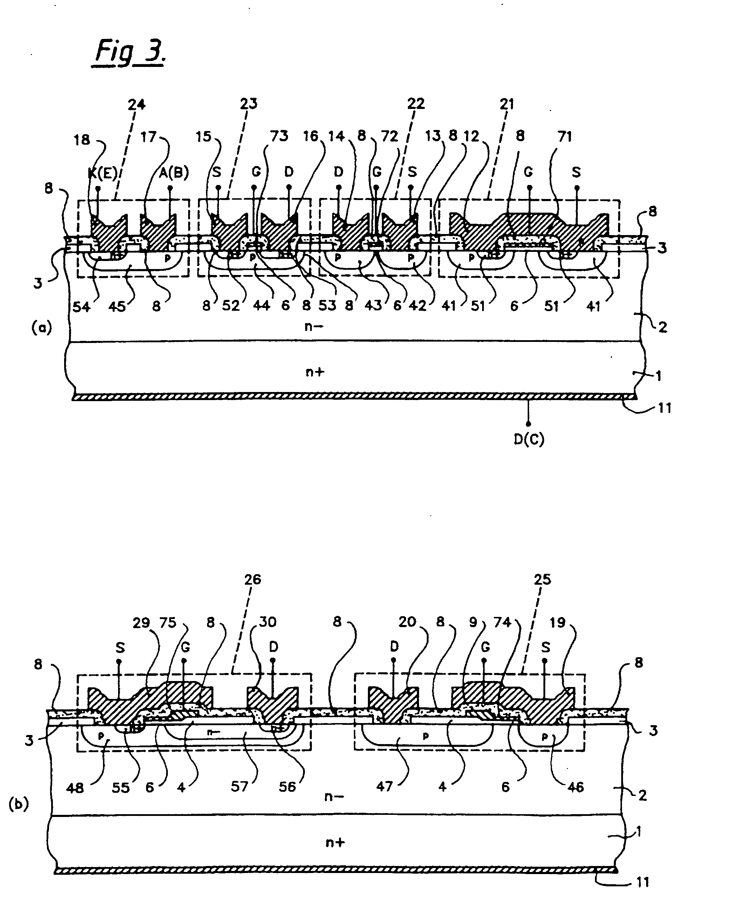

Figure 3 shows a cross-section of one example of the chip in the high-withstand voltage IC described above. The diagram is divided into drawings a and b. Formed on an n-layer 2 and grown epitaxially on an n⁺ substrate 1 are a vertical power MOSFET 21, a p-channel MOSFET 22, an n-channel MOSFET 23, a Zener diode 24, a high-withstand voltage p-channel MOSFET 25, and a high-withstand voltage n-channel MOSFET 26. In the vertical MOSFET 21, a p-well 41 is formed selectively on the surface layer of the n⁻ layer 2, an n⁺ source layer 51 is also formed on the surface layer thereof, and a gate electrode 71 is disposed on the part between the exposed sections of the n⁺ source layer 51 of the p-well 41 and the n⁻ layer 2 via the gate oxide films 6. Furthermore, a drain electrode 11 of this MOSFET is connected to the main power source VCC in contact with the rear of the n⁺ substrate 1, and is applied with a voltage from a battery, whereas a source electrode 12 is insulated by the gate electrode 71 and inter-layer insulation films 8 and makes contact with both the source layer 51 and the p-well 41. In the p-channel MOSFET 22, a p-source layer 42 and a p-drain layer 43 are formed on the surface layer of the n⁻ layer 2, a gate electrode 72 is disposed over the surfaces of the above source and drain layers via the gate oxide films 6, and the source layer 42 and the drain layer 43 make contact with a source electrode 13 and a drain electrode 14, respectively. In the n-channel MOSFET 23, a p-well 44 is formed in the surface layer of the n⁻ layer 2, an n⁺ source layer 52 and an n⁺ layer drain layer 53 are formed selectively on the surface layer thereof, and a gate electrode 73 is disposed over the surfaces of the above source and drain layers via the gate oxide films 6, while the source layer 52 makes contact with a source electrode 15 and the drain layer 53 makes contact with a drain electrode 16. A Zener diode 24 is composed of a p-anode layer 45 formed on the surface of the p⁻ layer 2 and an n-cathode layer 54 formed on the same surface, while the anode layer 45 makes contact with an anode electrode 17 and the cathode layer 54 makes contact with a cathode electrode 18.

The high-withstand voltage p-channel MOSFET 25 has a p-source layer 46, a p-drain layer 47 a gate electrode 74, a source electrode 19, and a drain electrode 20 via the gate oxide films 6, as does the p-channel MOSFET 22. Moreover, it also has a voltage withstand structure that consists of an extended section of the gate electrode 74 in the channel section between the source layer 46 and the drain layer 47, and the drain electrode 20, thick oxide films 4 and insulation films 8. In the high-withstand voltage n-channel MOSFET 26, a source layer 55 is an n⁺ layer formed on the surface of a p-well 48 as it is in the n-channel MOSFET 23. Meanwhile, an n⁻ drain layer 57 with a low impurity concentration is formed around a n⁺ drain layer 56, and the voltage withstand structure consists of an extended section of the gate electrode 75 between the channel section and a drain electrode 30. The thick oxide films 4 and the insulation films 8 are formed the same way as in the case of the MOSFET 25. A source electrode 29 makes contact with both the n⁺ source layer 55 and the p-well 48, while the drain electrode 30 makes contact with the n⁺ drain layer 56.

The high-withstand voltage IC as described above has the problems described below:
(1) The active elements constituting the high-withstand voltage circuit N all large-size elements like the high-withstand voltage p-channel MOSFET 25 and the n-channel MOSFET 26 are shown in Figure 3b. The size of these elements increase chip area and cost.
(2) Among the active elements constituting the low potential circuit L, the p-channel MOSFET 22, which must be high in withstand voltage against the n⁻ layer 3, requires the formation of a deep p-source layer 42 and the p-drain layer 43 by diffusion, which increases the size and decreases integration density.
(3) When the voltage from the main power source VCC applied to the drain electrode 11 varies due to voltage surges, the voltage in the source layer 42 of the p-channel MOSFET in the low potential circuit L, the voltage between the drain layer 43, and in the n⁻ layer 3 also varies to the same degree. Moreover, the displacement current generated by the junction capacity and voltage fluctuation flows may possibly cause maloperations.
(4) While disposing a comparator in the high-withstand voltage circuit N to detect the potential in the power output POUT is indispensable to protect against overcurrents and detect loads, the POUT potential varies largely from near the main power source VCC to GND. Hence, a high detection accuracy for the comparator cannot be maintained.

The present invention is intended to solve the above-mentioned problems and provide a low cost, reliable high-withstand voltage IC.

A high-withstand voltage integrated circuit according to the present invention is defined in claim 1.

Further embodiments are defined in claims 2-15.

An embodiment of the invention will now be described in detail with reference to the accompanying drawings, in which :
Figure 1 is an internal circuit diagram of a high-withstand voltage IC according to the present invention;
Figure 2 is an internal circuit diagram of a conventional high-withstand voltage IC;
Figures 3a and 3b show, in cross-section, the chip construction of a conventional high-withstand voltage IC;
Figure 4 is a circuit diagram of each power supply of a high-withstand voltage IC according to the present invention;
Figure 5 is a circuit diagram of an interface circuit between the high potential circuit and the low potential circuit of a high-withstand voltage IC according to the present invention;
Figure 6 is a circuit diagram of the interface circuit between the high potential circuit and the medium potential circuit in the high-withstand voltage IC according to the present invention;
Figure 7 is a circuit diagram of an interface circuit between the medium potential circuit and the low potential circuit of a high-withstand voltage IC according to the present invention; and,
Figure 8 is a cross-sectional drawing illustrating a chip construction.

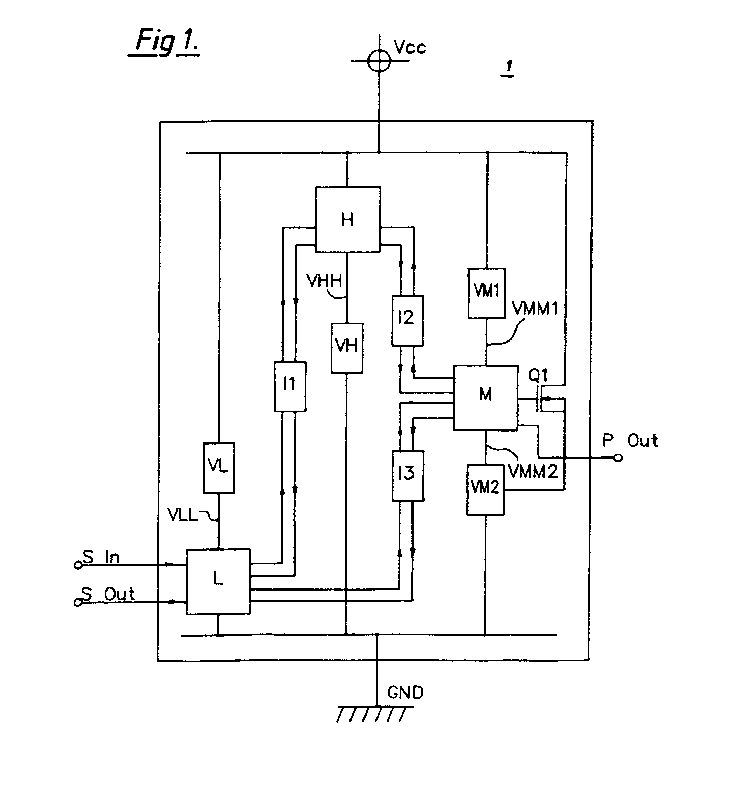

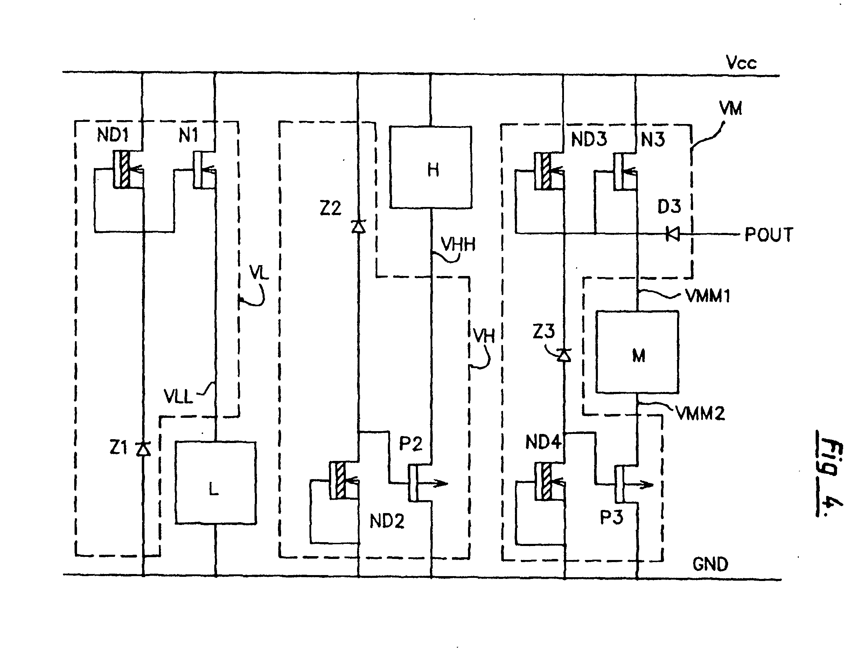

Figure 1 illustrates an internal circuit of the high-side, high-withstand voltage IC according to the present invention, with parts common to those in Figure 2 given the same numerals. In this IC, an input signal is inputted from the terminal SIN into the low potential circuit L. The low potential circuit L operates on the low potential power source circuit VL connected by the low potential power source line VLL. This low potential power source circuit VL is constructed as shown in Figure 4, for example. That is, the high potential side of the Zener diode Z1 as a constant voltage element is connected to the gate of an n-channel MOSFET N1, which has its source connected to the low potential power source line VLL and to the low potential side of a depression-type MOSFET ND1 connected with a gate and a source as the load elements.

Furthermore, the low potential side of the Zener diode Z1 and the low potential side of the low potential circuit L are connected to the terminal GND. A resistance may be used as a load element; however, a depression-type MOSFET can be used to greater advantage because of its small size. Signals from the low potential circuit L are transmitted to the high potential circuit H attached to the terminal VCC via the interface circuit 11 as shown in Figure 1, as well as to the medium potential circuit M connected to the medium potential power sources VM (VM1 and VM2), which is interlocked with the potential in the terminal POUT via the interface circuit 13. Diodes connected in series in the forward direction or a MOSFET with a drain and a gate connected that is connected in series may be used in place of Zener diodes as the constant voltage elements.

As shown in Figure 4 a high potential power source circuit VH connects the low potential side of the Zener diode Z2 to a gate of the p-channel MOSFET P2 connected to the power source line VHH in the high potential circuit H and to the high potential side of the depression MOSFET ND2 connected with a gate and a source as shown in Figure 4. A PNP transistor may also be used in place of this p-channel MOSFET P2. By constructing the VH circuit in this manner, the current flowing through the ND2 and Z2 generates a constant voltage against the high potential power source line of the VH connected to the terminal VCC at both ends of the Z2, the voltage being applied to the gate of the MOSFET P2 connecting a drain to the terminal GND to maintain the potential constant against the P2 source and a power source line of the high potential power source line pair. Thus, it is possible to make the line connected to the source of the MOSFET P2, and a high potential power source circuit VH can be formed.

A medium potential power source circuit VM, as shown in Figure 4, connects the depression MOSFETs ND3 and ND4 in series. Two gates and sources are then connected sandwiching the Zener diode Z3, which connects the high potential side of the ND3 and the drain of the n-channel MOSFET N3 to the terminal VCC, which connects the low potential side of the ND3 and the high potential side of the Z3 to the gate of the N3, which connects the low potential side of the Z3 and the high potential side of the ND4 to the gate of the p-channel MOSFET P3, and which connects the low potential side of the ND4 and the drain of P3 to the ground terminal. As a result of these arrangements, a certain potential difference is generated on both ends of the Zener diode Z3, with the high potential side of the Z3 controlling the gate of the n-channel MOSFET N3, and the low potential side controlling the gate of the p-channel MOSFET P3, thereby fixing the potential difference constant between the sources of the N3 and the P3. In addition, because the diode D3 connected between the terminal POUT and the high potential side of the Z3 makes the potential in the high potential side of the Z3 follow the potential in the power output, it is possible to construct a medium potential power source circuit VM that follows the potential in the power output which uses a line connected to the source of the N3 and a line connected to the source of the P3 as the high potential side line VMM1 and the low potential side line VMM2 of the medium potential power source line pair. If a comparator is formed in the VM, the fluctuation range of the comparator input to the comparator potential is reduced in size and the comparator detection accuracy can be increased because the VM follows the potential in the power output. While in Figure 4 the terminal POUT is connected t a point connecting a source to the gate short circuiting section in the ND3 to the gate of the N3 via the D3, the connection may be made at the point connecting the drain of the ND4 to the gate of the P3 via a diode. A MOSFET that connects a drain and a gate may be used in place of a diode as a rectification element. Such a construction may eliminate the medium potential circuit of the circuit in Figure 1, but will use only a high potential circuit connected to a low potential circuit and the high potential power source circuit VH.

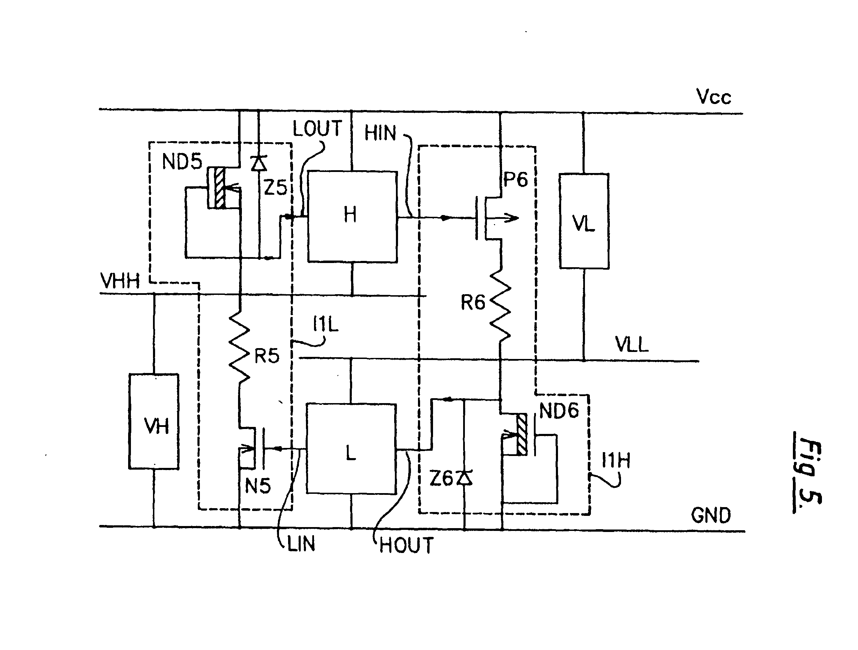

Figure 5 shows the interface circuit I1 between the high potential circuit H and the low potential circuit L. In this circuit, the I1L from L to H connects the n-channel MOSFET N5 with the depression MOSFET ND5, which is connected with the gate and source of the load element via the resistance R5 acting as the current-limiting element, and connects the Zener diode Z5 with ND5 in parallel, whereas the high potential side of the ND5 and the high potential side of the Zener diode Z5 are connected to the high potential line of the power source line pair for the high potential circuit H, and the low potential sides of the ND5 and Z5 and the high potential side of the R5 are connected with each other thereby acting as nodes to the signal output LOUT to H, and the source of the N5 is connected to the low potential line of the power source line pair for the low potential circuit L and the gate of the N5 acts as a node to the signal input LIN from L. The I1L operates as follows. If the gate of the N5 is given a low LIN signal from the voltage circuit L, the N5 turns off. As a result, the potential in the low potential side of the Z5 becomes equivalent to the potential of the high potential power line of the high potential power source line pair, that is the VCC, with which a high signal LOUT is sent to H. If the gate of the N5 is given a high LIN signal, the N5 turns on, and a constant voltage lower than the VCC determined by the Zener voltage of the Z5 is generated at the low potential side of the Z5, through which a low LOUT signal is sent to H. Thus, an interface circuit is constructed between two circuits with different potentials. The Zener voltage in the Zener diode Z5 must match the Zener voltage in the Zener diode Z2 of the high potential power source circuit VH shown in Figure 4.

On the other hand, the I1H from H to L connects the p-channel MOSFET P6 with the load element ND6 via the resistance R6, which is the current-limiting element, and connects the Zener diode Z6 with ND6 in parallel, whereas the low potential side of the ND6 and the Z6 are connected to the low potential line of the power source line pair for the low potential circuit L (that is a line leading to the terminal GND) and the high potential sides of the ND6 and Z6 and the low potential side of the R6 are connected with each other thereby acting as a node to the signal output HOUT to L, and the source of the P6 is connected to the high potential line of the power source line pair for H and the gate of the P6 acts as a node to the signal input HIN from H. In this I1H, the P6 turns on when the HIN signal is Low, with the HOUT signal becoming a voltage determined by the Zener voltage so that a High signal is inputted into L. The P6 turns off when the HIN signal is High, whereas the HOUT signal turns to GND, when it is Low. The characteristics of the Z6 must match those of Z1 in this case as well.

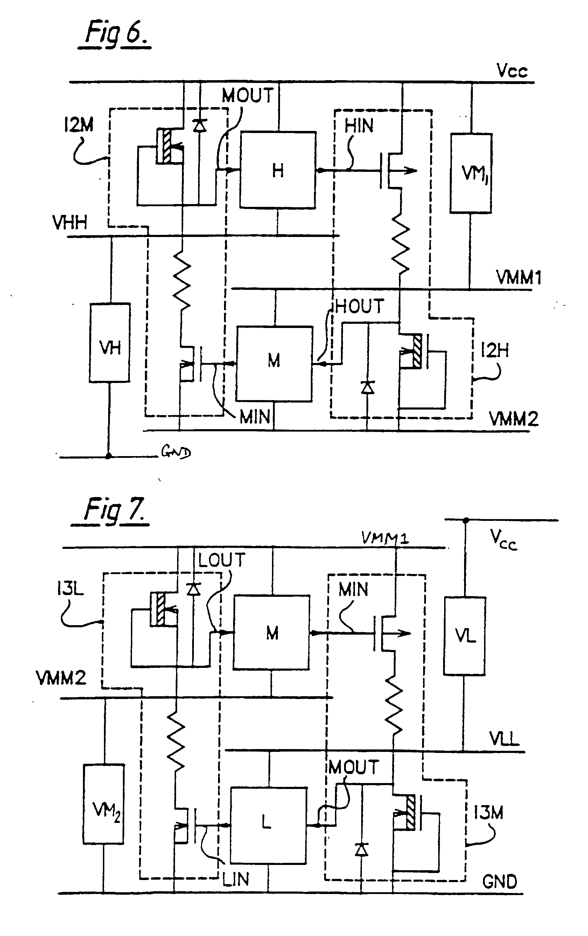

Figure 6 shows the interface circuit I2 between the high potential circuit H and the medium potential circuit M, while Figure 7 shows the interface circuit I3 between the medium potential circuit M and the low potential circuit L The configuration and operation of the circuits are identical with those in I1.

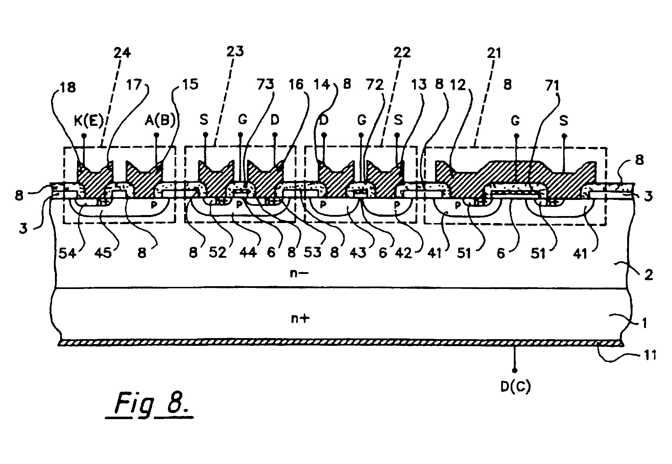

Figure 8 shows the part corresponding to the semiconductor chip in Figure 3a according to the embodiment of the present invention, with the parts common with those in Figure 3 assigned the same number. Because the logic circuit which has been integrated in the low potential circuit conventionally can be moved to the high potential circuit, the low-withstand voltage p-channel MOSFET 22 requires no high withstand voltage against the n⁻ layer 2. Therefore, the source layer 42 and the drain layer 43 are formed in a p-type diffusion layer that is shallower than in Figure 3, which reduces the size of the p-channel MOSFET 22 and improves its integration density. This embodiment which uses a MOSFET for the output stage can be applied equally to the case where an IGBT is used for the output stage. In that case a p⁺ substrate is used in place of an n⁺ substrate.

By making the power source to a high potential circuit dependent on a high potential power source line or disposing a medium potential circuit that depends on the medium potential power source line, the number of high-withstand voltage MOSFETs used in the analog section of the internal circuit of a high-withstand voltage IC can be greatly reduced, and the area of the semiconductor substrate can be decreased, leading to reduced costs. By shifting most of the low potential circuit to the high potential circuit, the source and drain layers of the p-channel MOSFET in the logic section can use shallower diffusion layers, thus improving the integration density and making maloperation due to voltage surges less likely. Furthermore, since the construction allows the formation of a comparator to detect the potential in the power output of the medium potential circuit which follows the potential of the power output, the fluctuation range of the comparator inputs to the comparator potential is reduced, enabling the comparator to maintain a high detection accuracy. The present invention can provide a low-cost, high-withstand voltage IC with a high integration density, surge durability and accuracy.

## Claims

1. A high-withstand voltage integrated circuit arranged such that it depends for its power on main power source line pair (Vcc-GND) comprising
at least one low potential power source circuit (VL) connected to the high potential side (Vcc) of the main power source line pair (Vcc-GND),
and at least one low potential power source line pair (VLL-GND) of said low potential power source circuit (L) and a low potential circuit (L) arranged such that it depends for its power on said low potential power source line pair (VLL-GND), and a high potential circuit (H) which is connected to the high potential side (Vcc) of the main power source line pair (Vcc-GND), and an interface circuit (I1, I1L) connected between the low potential circuit (L) and the high potential circuit (H), wherein
at least one high potential power source circuit (VH) which includes a constant voltage element (Z2) is connected to the low potential side (GND) of the main power source line pair (Vcc-GND),
wherein at least one high potential power source line pair (Vcc-VHH) of said high potential power source circuit (VH)is present,
wherein said interface circuit (I₁, I₁L) is connected to said main power source line pair (Vcc-GND), and the low potential circuit (L) is connected between the high potential side (VLL) of the low potential power source line pair (VLL-GND) and the low potential side (GND),
wherein the high potential circuit (H) is connected between the high potential side (Vcc) of the high potential power source line pair (Vcc-VHH) and the low potential side (VHH) thereof,
wherein the high potential side (Vcc) of the high potential power source line pair (Vcc-VHH) is connected to the high potential side (Vcc) of the main power source line pair (Vcc-GND) and the low potential side (GND) of the low potential power source line pair (VLL-GND) is connected to the low potential side (GND) of the main power source line pair (Vcc-GND), and,
wherein the interface circuit (I1) is connected between the high potential side (Vcc) and the low potential side (GND) of the main power source line pair (Vcc-GND) and wherein the interface circuit (I1) is further connected to the low potential circuit (L) and the high potential circuit (H), and the interface circuit is arranged to transmit signals between the low potential circuit (L) and the high potential circuit (H).

2. A high-withstand voltage integrated circuit according to claim 1 wherein at least one medium potential power source circuit (VM) is connected between the main power source line pair (Vcc-GND) and at least one medium potential power source line pair (VMM1-VMM2) of medium potential power source circuit (VM) and a medium potential circuit (M) arranged such that it depends for its power on said medium potential power source line pair (VMM1-VMM2).

3. A high-withstand voltage integrated circuit according to claim 1 or claim 2 in which said high potential power source circuit (VH) has at least one passive constant voltage element (Z2), at least one load element (ND2), and at least one p-channel MOSFET (P2); the high potential sides of the passive constant voltage element (Z2) is connected to the high potential side (Vcc) in the high potential line pair (Vcc-VHH); the low potential side of the passive constant voltage element (Z2) is connected to the high potential side of the load element (ND2) and to a gate of the p-channel MOSFET (P2); the low potential side of the load element (ND2) and a drain in the p-channel MOSFET (P2) are connected to a ground terminal (GND); and a source in the p-channel MOSFET (P2) is connected to the low potential side (VHH) of the high potential power source line pair (Vcc-VHH).

4. A high-withstand voltage integrated circuit according to claim 1 or claim 2 in which a high potential power source circuit (VH) has at least one passive constant voltage element (Z2), at least one load element (ND2), and at least one PNP transistor (P2); the high potential sides of the passive constant voltage element (Z2) is connected to the high potential side (Vcc) in the high potential line pair (Vcc-VHH); the low potential side of the passive constant voltage element (Z2) is connected to the high potential side of the load element (ND2) and a base of the PNP transistor (P2); the low potential side of the load element (ND2) and a collector in the PNP transistor (P2) are connected to a ground terminal (GND); and an emitter in the PNP transistor (P2) is connected to the low potential line (VHH) of the high potential power source line pair (Vcc-VHH).

5. A high-withstand voltage integrated circuit according to claim2 in which a medium potential power source circuit (VM) has at least one passive constant voltage element (Z3), at least two load elements (ND3, ND4), at least one p-channel MOSFET (P3), and at least one n-channel MOSFET (N3); the high potential side of the first load element (ND3) and the drain of the n-channel MOSFET (N3) are connected to the main power source terminal (Vcc); the low potential side of the first load element (ND3) is connected to the high potential side of the passive constant voltage element (Z3) and the gate of the n-channel MOSFET (N3); the low potential side of the passive constant voltage element (Z3) is connected to the high potential side of the second load element (ND4) and to the gate of the p-channel MOSFET (P3); the low potential side of the second load element (ND4) and the drain of the p-channel MOSFET (P3) are connected to a ground terminal (GND); a source in the n-channel MOSFET (N3) is connected to the high potential line of the medium potential power source line pair (VMM1); and a source in the p-channel MOSFET (P3) is connected to the low potential line of the medium potential power source line pair (VMM2).

6. A high-withstand voltage integrated circuit according to claim5 in which the low potential side of the first load element (ND3) the high potential side of the passive constant voltage element (Z3), and the gate of the n-channel MOSFET (N3) are connected to power output terminals via rectification elements (D3).

7. A high-withstand voltage integrated circuit according to claim6 in which said rectification elements (D3) consist of diodes.

8. A high-withstand voltage integrated circuit according any of the claims 3, 4, 5, 6 or 7 in which at least one of the load elements (ND2, ND3, ND4) is a depression-type MOSFET to which a gate and source are connected.

9. A high-withstand voltage integrated circuit according any of the claims 3, 4, 5, 6 or 7 in which at least one of the load elements (ND2, ND3, ND4) is a resistance.

10. A high-withstand voltage integrated circuit according to any one of the claims 1 to 6, having an interface circuits (I1L, I2M, I3L) that mediates signals between two circuits with different potentials in which the interface circuit is equipped with a n-channel MOSFET, a load element (ND5), a passive constant voltage element (Z5), and a current-limiting element (R5); the high potential sides of the load element (ND5) and the constant voltage element (Z5) are connected to the high potential lines in the power source pair of the circuit of higher potential; the low potential sides of the load element (ND5) and the passive constant voltage element (Z5), and the high potential side of the current-limiting element (R5), are connected with each other, and act as signal output nodes to the circuit of higher potential; the low potential side of the current-limiting element (R5) is connected to the drain of the n-channel MOSFET (N5); the source of the n-channel MOSFET (N5) is connected to the low potential line of the power source line pair of the circuit of lower potential; and the gate of the n-channel MOSFET (N5) acts as a signal input node from the circuit of lower potential.

11. A high-withstand voltage integrated circuit according to any of the claims 1 to 6, having an interface circuit (I1H,I2H,I3M) that mediates signals between two circuits with different potentials in which the interface circuit is equipped with a p-channel MOSFET (P6); a load element (ND6), a passive constant voltage element (Z6), and a current-limiting element (R6); the low potential sides of the load element (ND6) and the constant voltage element (Z6) are connected to the low potential line in the power source line pair of the circuit of lower potential; the high potential sides of the load element (ND6) and the passive constant voltage element (Z6), and the low potential side of the current-limiting element (R6), are connected with each other, and act as signal output nodes to the circuit of lower potential; the high potential side of the current-limiting element (R6) is connected to the drain of the p-channel MOSFET (P6); the source of the p-channel MOSFET (P6) is connected to the high potential line of the power source line pair of the circuit of higher potential; and the gate of the p-channel MOSFET (P6) acts as a signal input node from the circuit of higher potential.

12. A high-withstand voltage integrated circuit according to claims 10 or 11 in which the current-limiting element is a resistance (R5, R6).

13. A high-withstand voltage integrated circuit according to claims 10 or 11 in which the load element is a depression-type MOSFET (ND5, ND6) to which a gate and source are connected.

14. A high-withstand voltage integrated circuit according to claims 10 or 11 in which the load element is a resistance.

15. A high-withstand voltage integrated circuit according to claims 10 or 11 in which the constant voltage element is a Zener diode (Z5, Z6).

## Patentansprüche

1. Integrierte Schaltung mit hoher Spannungsfestigkeit, die so angeordnet ist, dass ihre Leistung von einem Leitungspaar einer Haupt-Leistungsquelle (Vcc-GND) abhängt, umfassend
mindestens eine Niederspannungs-Leistungsquellen-Schaltung (VL), die mit der Hochspannungsseite (Vcc) des Leitungspaares einer Haupt-Leistungsquelle (Vcc-GND) verbunden ist,
und mindestens einem Leitungspaar einer Niederspannungs-Leistungsquelle (VLL-GND) der Niederspannungs-Leistungsquellen-Schaltung (VL) und einer Niederspannungs-Schaltung (L), die so angeordnet ist, dass ihre Leistung vom Leitungspaar der Niederspannungs-Leistungsquelle (VLL-GND) abhängt, und einer Hochspannungs-Schaltung (H), die mit der Hochspannungsseite (Vcc) des Leitungspaares der Haupt-Leistungsquelle (Vcc-GND) verbunden ist, und einer Schnittstellen-Schaltung (I1, I1L), die zwischen der Niederspannungs-Schaltung (L) und der Hochspannungs-Schaltung (H) verbunden ist, worin
mindestens eine Hochspannungs-Leistungsquellen-Schaltung (VH), die ein Konstantspannungselement (Z2) enthält, mit der Niederspannungsseite (GND) des Leitungspaares der Haupt-Leistungsquelle (Vcc-GND) verbunden ist,
worin mindestens ein Leitungspaar der Hochspannungs-Leistungsquelle (Vcc-VHH) der Hochspannungs-Leistungsquellen-Schaltung (VH) vorhanden ist,
worin die Schnittstellen-Schaltung (I1, I1L) mit dem Leitungspaar der Haupt-Leistungsquelle (Vcc-GND) verbunden ist, und die Niederspannungs-Schaltung (L) zwischen der Hochspannungsseite (VLL) des Leitungspaares der Niederspannungs-Leistungsquelle (VLL-GND) und dessen Niederspannungsseite (GND) verbunden ist,
worin die Hochspannungs-Schaltung (H) zwischen der Hochspannungsseite (Vcc) des Leitungspaares der Hochspannungs-Leistungsquelle (Vcc-VHH) und dessen Niederspannungsseite (VHH) verbunden ist,
worin die Hochspannungsseite (Vcc) des Leitungspaares der Hochspannungs-Leistungsquelle (Vcc-VHH) mit der Hochspannungsseite (Vcc) des Leitungspaares der Haupt-Leistungsquelle (Vcc-GND) verbunden ist und die Niederspannungsseite (GND) des Leitungspaares der Niederspannungs-Leistungsquelle (VLL-GND) mit der Niederspannungsseite (GND) des Leitungspaares der Haupt-Leistungsquelle (Vcc-GND) verbunden ist, und
worin die Schnittstellen-Schaltung (I1) zwischen der Hochspannungsseite (Vcc) und der Nicderspannungsseite (GND) des Leitungspaares der Haupt-Leistungsquelle (Vcc-GND) verbunden ist, und worin die Schnittstellen-Schaltung (I1) weiter mit der Niederspannungs-Schaltung (L) und der Hochspannungs-Schaltung (H) verbunden ist, und die Schnittstellen-Schaltung ist angeordnet, um Signale zwischen der Niederspannungs-Schaltung (L) und der Hochspannungs-Schaltung (H) zu übertragen.

2. Integrierte Schaltung mit hoher Spannungsfestigkeit nach Anspruch 1, worin mindestens eine Mittelspannungs-Leistungsquellen-Schaftung (VM) zwischen dem Leitungspaar der Haupt-Leistungsquelle (Vcc-GND) und mindestens einem Leitungspaar der Mittelspannungs-Leistungsquelle (VMM1-VMM2) der Mittelspannungs-Leistungsquellen-Schaltung (VM) und einer Mittelspannungs-Schaltung (M), die so angeordnet ist, dass ihre Leistung von dem Leitungspaar der Mittelspannungs-Leistungsquelle (VMM1-VMM2) abhängt, verbunden ist.

3. Integrierte Schaltung mit hoher Spannungsfestigkeit nach Anspruch 1 oder 2, bei der die Hochspannungs-Leistungsquellen-Schaltung (VH) mindestens ein passives Konstantspannungselement (Z2), mindestens ein Lastelement (ND2) und mindestens einen p-Kanal-MOSFET (P2) hat; die Hochspannungsseite des passiven Konstantspannungselements (Z2) ist mit der Hochspannungsseite (Vcc) des Hochspannungs-Leitungspaares (Vcc-VHH) verbunden; die Niederspannungsseite des passiven Konstantspannungselement (Z2) ist mit der Hochspannungsseite des Lastelements (ND2) und mit dem Gate des p-Kanal-MOSFET (P2) verbunden; die Niederspannungsseite des Lastelements (ND2) und eine Drain des p-Kanal-MOSFET (P2) sind mit dem Masseanschluss (GND) verbunden; und eine Source des p-Kanal-MOSFET (P2) ist mit der Niederspannungsseite (VHH) des Leitungspaares der Hochspannungs-Leistungsquelle (Vcc-VHH) verbunden.

4. Integrierte Schaltung mit hoher Spannungsfestigkeit nach Anspruch 1 oder 2, bei der eine Hochspannungs-Leistungsquellen-Schaltung (VH) mindestens ein passives Konstantspannungselement (Z2), mindestens ein Lastelement (ND2) und mindestens einen PNP-Transistor (P2) hat; die Hochspannungsseite des passiven Konstantspannungselements (Z2) ist mit der Hachspannungsseite (Vcc) des Hochspannungs-Leitungspaares (Vcc-VHH) verbunden; die Niederspannungsseite des passiven Konstantspannungselements (Z2) ist mit der Hochspannungsseite des Lastelements (ND2) und einer Basis des PNP-Transistors (P2) verbunden; die Niederspannungsseite des Lastelements (ND2) und ein Kollektor des PNP-Transistors (P2) sind mit einem Masseanschluss (GND) verbunden; und ein Emitter des PNP-Transistors (P2) ist mit der Niederspannungs-Leitung (VHH) des Leitungspaares der Hochspannungs-Leistungsquelle (Vcc-VHH) verbunden.

5. Integrierte Schaltung mit hoher Spannungsfestigkeit nach Anspruch 2, bei der eine Mittelspannungs-Leistungsquellen-Schaltung (VM) mindestens ein passives Konstantspannungselement (Z3), mindestens zwei Lastelemente (ND3, ND4), und mindestens einen p-Kanal-MOSFET (P3) und mindestens einen n-Kanal-MOSFET (N3) hat; die Hochspannungsseite des ersten Lastelements (ND3) und die Drain des n-Kanal-MOSFET (N3) sind mit dem Haupt-Leistungsquellen-Anschluss (Vcc) verbunden; die Niederspannungsseite des ersten Lastelements (ND3) ist mit der Hochspannungsseite des passiven Konstantspannungselements (Z3) und dem Gate des n-Kanal-MOSFET (N3) verbunden; die Niederspannungsseite des passiven Konstantspannungselements (Z3) ist mit der Hochspannungsseite des zweiten Lastelements (ND4) und mit dem Gate des p-Kanal-MOSFET (P3) verbunden; die Niederspannungsseite des zweiten Lastelements (ND4) und die Drain des p-Kanal-MOSFET (P3) sind mit einem Masseanschluss (GND) verbunden; eine Quelle des n-Kanal-MOSFET (N3) ist mit der Hochspannungs-Leitung des Leitungspaares der Mittelspannungs-Leistungsquelle (VMM1) verbunden; und eine Source des p-Kanal-MOSFET (P3) ist mit der Niederspannungs-Leitung des Lcitungspaares der Mittelspannungs-Leistungsquelle (VMM2) verbunden.

6. Integrierter Schaltung mit hoher Spannungsfestigkeit nach Anspruch 5, bei der die Niederspannungsseite des ersten Lastelements (ND3), die Hochspannungsseite des passiven Konstantspannungselements (Z3) und das Gate des n-Kanal-MOSFET (N3) mit den Leistungsausgangsanschlüssen über Gleichrichtelemente (D3) verbunden sind.

7. Integrierte Schaltung mit hoher Spannungsfestigkeit nach Anspruch 6, bei der die Gleichrichtelemente (D3) aus Dioden bestehen.

8. Integrierte Schaltung mit hoher Spannungsfestigkeit nach einem der Ansprüche 3, 4, 5, 6 oder 7, bei der mindestens eines der Lastelemente (ND2, ND3, ND4) ein MOSFET vom Verarmungstyp ist, bei dem ein Gate und eine Source verbunden sind.

9. Integrierte Schaltung mit hoher Spannungsfestigkeit nach einem der Ansprüche 3, 4, 5, 6 oder 7, bei der mindestens eines der Lastelemente (ND2, ND3, ND4) ein Widerstand ist.

10. Integrierte Schaltung mit hoher Spannungsfestigkeit nach einem der Ansprüche 1 bis 6, die eine Schnittstellen-Schaltung (I1L, I2M, I3L) hat, die Signale zwischen zwei Schaltungen mit unterschiedlichen Spannungen vermittelt, bei der die Schnittstellen-Schaltung mit einem n-Kanal-MOSFET, einem Lastelement (ND5), einem passiven Konstantspannungselement (Z5), und einem Strombegrenzungselement (R5) ausgestattet ist; die Hochspannungsseiten des Lastelements (NDS) und des Konstantspannungselements (Z5) sind mit den Hochspannungs-Leitungen des Leistungsquellenpaares der Schaltung mit höherer Spannung verbunden; die Niederspannungsseite des Lastelements (ND5) und des passiven Konstantspannungselements (Z5) und die Hochspannungsseite des Strombegrenzungselements (R5) sind miteinander verbunden, und dienen als Signalausgangsknoten an die Schaltung mit höhere Spannung; die Niederspannungsseite des Strombegrenzungselements (R5) ist mit der Drain des n-Kanal-MOSFET (N5) verbunden; die Source des n-Kanal-MOSFET (N5) ist mit der Niederspannungs-Leitung des Leistungsquellen-Leitungspaares der Schaltung mit niedrigerer Spannung verbunden; und das Gate des n-Kanal-MOSFET (N5) dient als Signaleingangsknoten von der Schaltung mit niedrigerer Spannung.

11. Integrierte Schaltung mit hoher Spannungsfestigkeit nach einem der Ansprüche 1 bis 6, die eine Schnittstellen-Schaltung (I1H, I2H, I3N) hat, die Signale zwischen zwei Schaltungen mit unterschiedlichen Spannungen vermittelt, bei der die Schnittstellen-Schaltung mit einem p-Kanal-MOSFET (P6); einem Lastelement (ND6), einem passiven Konstantspannungselement (Z6) und einem Strombegrenzungselement (R6) ausgestattet ist; die Niederspannungsseite des Lastelements (ND6) und des Konstantspannungselements (Z6) sind mit der Niederspannungs-Leitung des Niederspannungs-Leitungspaares der Schaltung mit niedrigerer Spannung verbunden; die Hochspannungsseite des Lastelements (ND6) und des passiven Konstantspannungselements (Z6) und die Niederspannungsseite des Strombegrenzungselements (R6) sind miteinander verbunden, und dienen als Signalausgangsknoten an die Schaltung mit niedrigerer Spannung; die Hochspannungsseite des Strombegrenzungselements (R6) ist mit der Drain des p-Kanal MOSFET (P6) verbunden; die Source des p-Kanal-MOSFET (P6) ist mit der Hochspannungs-Leitung des Leistungsquellen-Leitungspaares der Schaltung mit niedrigerer Spannung verbunden; und das Gate des p-Kanal-MOSFET (P6) dient als Signaleingangsknoten von der Schaltung mit höherer Spannung.

12. Integrierte Schaltung mit hoher Spannungsfestigkeit nach Anspruch 10 oder 11, bei der das Strombegrenzungselement ein Widerstand (R5, R6) ist.

13. Integrierte Schaltung mit hoher Spannungsfestigkeit nach Anspruch 10 oder 11, bei der das Lastelement ein MOSFET (ND5, ND6) vom Verarmungstyp ist, bei dem ein Gate und eine Source verbunden sind.

14. Integrierte Schaltung mit hoher Spannungsfestigkeit nach Anspruch 10 oder 11, bei der das Lastelement ein Widerstand ist.

15. Integrierte Schaltung mit hoher Spannungsfestigkeit nach Anspruch 10 oder 11, bei dem das Konstantspannungselement eine Zenerdiode (Z5, Z6) ist.

## Revendications

1. Circuit intégré à haute tension de maintien, conçu de façon à dépendre, pour son alimentation électrique, d'une paire de lignes formant source d'alimentation principale (Vcc-GND), comprenant
au moins un circuit formant source d'alimentation à bas potentiel (VL) connecté au côté à haut potentiel (Vcc) de la paire de lignes formant source d'alimentation principale (Vcc-GND),
et au moins une paire de lignes formant source d'alimentation à bas potentiel (VLL-GND) dudit circuit formant source d'alimentation à bas potentiel (VL) et un circuit à bas potentiel (L) conçu de façon à dépendre, pour son alimentation électrique, de ladite paire de lignes formant source d'alimentation à bas potentiel (VLL-GND), et un circuit à haut potentiel (H) qui est connecté au côté à haut potentiel (Vcc) de la paire de lignes formant source d'alimentation principale (Vcc-GND), et un circuit d'interface (I1, I1L) connecté entre le circuit à bas potentiel (L) et le circuit à haut potentiel (H), dans lequel
au moins un circuit formant source d'alimentation à haut potentiel (VH) qui comporte un élément à tension constante (Z2) est connecté au côté à bas potentiel (GND) de la paire de lignes formant source d'alimentation principale (Vcc-GND),
dans lequel au moins une paire de lignes formant source d'alimentation à haut potentiel (Vcc-VHH) dudit circuit (VH) formant source d'alimentation à haut potentiel est présente,
dans lequel ledit circuit d'interface (I1, I1L) est connecté à ladite paire de lignes de source d'alimentation principale (Vcc-GND), et le circuit à bas potentiel (L) est connecté entre le côté à haut potentiel (VLL) de la paire de lignes formant source d'alimentation à bas potentiel (VLL-GND) et le côté à bas potentiel (GMD),
dans lequel le circuit à haut potentiel (H) est connecté entre le côté à haut potentiel (Vcc) de la paire de lignes formant source d'alimentation à haut potentiel (Vcc-VHH) et le côté à bas potentiel (VHH) de celle-ci,
dans lequel le côté à bas potentiel (Vcc) de la paire de lignes formant source d'alimentation à haut potentiel (Vcc-VHH) est connecté au côté à haut potentiel (Vcc) de la paire de lignes formant source d'alimentation principale (Vcc-GND) et le côté à bas potentiel (GND) de la paire de lignes de source d'alimentation à bas potentiel (VLL-GND) est connecté au côté à bas potentiel (GND) de la paire de lignes de source d'alimentation principale (Vcc-GND), et
dans lequel le circuit d'interface (I1) est connecté entre le côté à haut potentiel (Vcc) et le côté à bas potentiel (GND) de la paire de lignes de source d'alimentation principale (Vcc-GND), et le circuit d'interface (I1) est en outre connecté au circuit à bas potentiel (L) et au circuit à haut potentiel (H), et le circuit d'interface étant conçu pour émettre des signaux entre le circuit à bas potentiel (L) et le circuit à haut potentiel (H).

2. Circuit intégré à haute tension de maintien selon la revendication 1, dans lequel au moins un circuit formant source d'alimentation à potentiel moyen (VM) est connecté entre la paire de lignes formant source d'alimentation principale (Vcc-GND) et au moins une paire de lignes formant source d'alimentation à potentiel moyen (VMM1 - VMM2) du circuit formant source d'alimentation à potentiel moyen (VM) et un circuit à potentiel moyen (M) conçu de façon à dépendre, pour son alimentation, de ladite paire de lignes formant source d'alimentation à potentiel moyen (VMM1 - VMM2).

3. Circuit intégré à haute tension de maintien selon la revendication 1 ou la revendication 2, dans lequel ledit circuit formant source d'alimentation à haut potentiel (VH) a au moins un élément passif à tension constante (Z2), au moins un élément de charge (ND2) et au moins un MOSFET à canal P (P2) ; les côtés à haut potentiel de l'élément passif à tension constante (Z2) sont connectés au côté à haut potentiel (Vcc) de la paire de lignes à haut potentiel (Vcc-VHH) ; le côté à bas potentiel de l'élément passif à tension constante (Z2) est connecté au côté à haut potentiel de l'élément de charge (ND2) et à une grille du MOSFET (P2) à canal P ; le côté à bas potentiel de l'élément de charge (ND2) et un drain dans le MOSFET à canal P sont connectés à une borne de masse (GND) ; et une source du MOSFET (P2) à canal P est connectée au côté à bas potentiel (VHH) de la paire de lignes formant source d'alimentation à haut potentiel (Vcc-VHH).

4. Circuit intégré à haute tension de maintien selon la revendication 1 ou la revendication 2, dans lequel un circuit formant source d'alimentation à haut potentiel (VH) a au moins un élément passif à tension constante (Z2), au moins un élément de charge (ND2) et au moins un transistor P-N-P (P2) ; les côtés à haut potentiel de l'élément passif à tension constante (Z2) sont connectés au côté à haut potentiel (Vcc) de la paire de lignes à haut potentiel (Vcc-VHH) ; le côté à bas potentiel de l'élément passif à tension constante (Z2) est connecté au côté à haut potentiel de l'élément de charge (ND2) et à une base du transistor P-N-P (P2) ; le côté à bas potentiel de l'élément de charge (ND2) et un collecteur du transistor P-N-P (P2) sont connectés à une borne de masse (GND) ; et un émetteur du transistor P-N-P (P2) est connecté à la ligne de bas potentiel (VHH) de la paire de lignes de source d'alimentation à haut potentiel (Vcc-VHH).

5. Circuit intégré à haute tension de maintien selon la revendication 2, dans lequel un circuit formant source d'alimentation à potentiel moyen (VM) a au moins un élément passif à tension constante (Z3), au moins deux éléments de charge (ND3, ND4), au moins un MOSFET à canal P (P3) et au moins un MOSFET à canal N (N3) ; le côté à haut potentiel du premier élément de charge (ND3) et le drain du MOSFET à canal N (N3) sont connectés à la borne de source d'alimentation principale (Vcc) ; le côté à bas potentiel du premier élément de charge (ND3) est connecté au côté à haut potentiel de l'élément passif à tension constante (Z3) et à la grille du MOSFET à canal N (N3) ; le côté à bas potentiel de l'élément passif (Z3) à tension constante est connecté à un côté à haut potentiel du second élément de charge (ND4), et à la grille du MOSFET à canal P (P3) ; le côté à bas potentiel du second élément de charge (ND4) et le drain du MOSFET à canal P (P3) sont connectés à une borne de masse (GND) ; une source du MOSFET à canal N (N3) est connectée à la ligne à haut potentiel de la paire de lignes de source d'alimentation à potentiel moyen (VMM1) ; et une source présente dans le MOSFET d'alimentation P (P3) est connectée à la ligne de bas potentiel de la paire de lignes de source d'alimentation à potentiel moyen (VMM2).

6. Circuit intégré à haute tension de maintien selon la revendication 5, dans lequel le côté à bas potentiel du premier élément de charge (ND3), le côté à haut potentiel de l'élément passif à tension constante (Z3) et la grille du MOSFET à canal N (N3) sont connectés à des bornes de sortie de puissance via des éléments de redressement (D3).

7. Circuit intégré à haute tension de maintien selon la revendication 6, dans lequel lesdits éléments de redressement (D3) sont constitués par des diodes.

8. Circuit intégré à haute tension de maintien selon l'une quelconque des revendications 3, 4, 5, 6 ou 7, dans lequel au moins un des éléments de charge (ND2, ND3, ND4) est un MOSFET du type à déplétion auquel sont connectées une grille et une source.

9. Circuit intégré à haute tension de maintien selon l'une quelconque des revendications 3, 4, 5, 6 ou 7, dans lequel au moins un des éléments de charge (ND2, ND3, ND4) est une résistance.

10. Circuit intégré à haute tension de maintien selon l'une quelconque des revendications 1 à 6, ayant un circuit d'interface (I1L, I2M, I3L) qui sert d'intermédiaire pour les signaux entre deux circuits à potentiels différents, dans lequel le circuit d'interface est équipé d'un MOSFET à canal N, d'un élément de charge (ND5), d'un élément passif à tension constante (Z5) et d'un élément limiteur de courant (R5) ; les côtés à haut potentiel de l'élément de charge (ND5) et de l'élément à tension constante (Z5) sont connectés aux lignes à haut potentiel de la paire de lignes de source d'alimentation du circuit à potentiel le plus haut ; les côtés à bas potentiel de l'élément de charge (ND5) et de l'élément passif à tension constante (Z5), et le côté à haut potentiel de l'élément limiteur de courant (R5) sont connectés l'un à l'autre et servent de noeud de sortie de signaux pour le circuit au potentiel le plus haut ; le côté à bas potentiel de l'élément limiteur de courant (R5) est connecté au drain du MOSFET à canal N (N5) ; la source du MOSFET à canal N (N5) est connectée à la ligne de bas potentiel de la paire de lignes de source d'alimentation du circuit au potentiel le plus bas ; et la grille du MOSFET à canal N (N5) sert de noeud d'entrée de signaux à partir du circuit au potentiel le plus bas.

11. Circuit intégré à haute tension de maintien selon l'une quelconque des revendications 1 à 6, ayant un circuit d'interface (I1H, I2H, I3M) qui sert d'intermédiaire pour les signaux entre deux circuits à potentiels différents, dans lequel le circuit d'interface est équipé d'un MOSFET à canal P (P6), d'un élément de charge (ND6), d'un élément passif à tension constante (Z6) et d'un élément limiteur de courant (R6) ; les côtés à bas potentiel de l'élément de charge (ND6) et de l'élément à tension constante (Z6) sont connectés à la ligne de bas potentiel de la paire de lignes de source d'alimentation du circuit au potentiel le plus bas ; les côtés à haut potentiel de l'élément de charge (ND6) et de l'élément passif à tension constante (Z6), et le côté à bas potentiel de l'élément limiteur de courant (R6) sont connectés les uns aux autres et servent de noeuds de sortie de signaux vers le circuit au potentiel le plus bas ; le côté à haut potentiel de l'élément limiteur de courant (R6) est connecté au drain du MOSFET à canal P (P6) ; la source du MOSFET à canal P (P6) est connectée à la ligne à haut potentiel de la paire de lignes de source d'alimentation du circuit au potentiel le plus haut ; et la grille du MOSFET à canal P (P6) sert de noeud d'entrée de signal à partir du circuit au potentiel le plus haut.

12. Circuit intégré à haute tension de maintien selon la revendication 10 ou 11, dans lequel l'élément limiteur de courant est une résistance (R5, R6).

13. Circuit intégré à haute tension de maintien selon la revendication 10 ou 11, dans lequel l'élément de charge est un MOSFET du type à déplétion (ND5, ND6), auquel sont connectées une grille et une source.

14. Circuit intégré à haute tension de maintien selon la revendication 10 ou 11, dans lequel l'élément de charge est une résistance.

15. Circuit intégré à haute tension de maintien selon la revendication 10 ou 11, dans lequel l'élément à tension constante est une diode Zener (Z5, Z6).
